# EUROPÄISCHE PATENTANMELDUNG

(11) **EP 0 780 979 A2**
(43) Veröffentlichungstag der Anmeldung: **25.06.1997**
(21) Anmeldenummer: 96119572.4
(22) Anmeldetag: 05.12.1996
(51) Int. Cl.: H03K 17/96

(54) **Betätigungsvorrichtung mit zumindest einem optoelektronischen Tastenelement**

(30) Priorität: 18.12.1995 DE 19547301
(71) Anmelder: SIEMENS AKTIENGESELLSCHAFT, 80333 München (DE)
(72) Erfinder: Gay, Thomas, Dipl.-Ing., 89160 Dornstadt (DE)

(57) **Zusammenfassung**

Um trotz toleranz- und insbesondere temperatur- bzw. alterungsbedingter Streuungen aus dem bei Betätigung zumindest eines Tastenelementes (T1-T6) empfangenen reflektierten, insbesondere analogen, pulsförmigen Wechsel-Schaltsignal ohne Notwendigkeit einer Nachjustierung eine eindeutige Signalerkennung zur Abgabe eines, insbesondere digitalen, entsprechenden EIN/AUS-Stellbefehls der Betätigungsvorrichtung (CO) ableiten zu können, steht ein den EIN/AUS-Wechsel erkennender Schwellwert (u_{c}) eines Komparators (K) in Einstell- bzw. Nachführabhängigkeit vom Reflexionsgrad eines dem pulsförmigen Wechsel-Nutzlichtsignale (u₊) überlagerten Gleich-Prüflichtsignals (u₋).

## Beschreibung

Die Erfindung bezieht sich auf eine Betätigungsvorrichtung mit zumindest einem optoelektronischen Tastenelement gemäß Patentanspruch 1.

Optoelektronische Tastenelemente, insbesondere berührungsempfindliche Reflexlichtschranken, enthalten eine elektronische Baugruppe mit einem Sender und einem Empfänger, wobei bei Betätigung des Tastenelementes eine von dem Sender ausgeschickte Infrarot-Strahlung als Betätigungssignal an einem Reflexkörper zum Empfänger reflektiert und in einem Komparator als Tastenbetätigung detektiert wird. Zur Lichtemission werden in der Regel zyklisch, z.B. von einem Controller, angesteuerte, im Pulsbetrieb arbeitende Infrarot-Leuchtdioden (IR-LED) und als Empfänger auf den reflektierten Infrarotstrahl ansprechende Foto-Transistoren vorgesehen. Diese Empfänger können erst dann ansprechen, wenn aufgrund der Tastenberührung ein reflektierter Nutzlichtstrahl auf den Sender auftritt.

Um zur Betätigung derartiger Schaltvorgänge den Betätigungszuständen"EIN" bzw."AUS" des Tastenelementes entsprechende, insbesondere digitale, Ausgangssignale für weitere Schaltbefehle zuordnen zu können, werden die Komparatoren in der Regel als sogenannte Amplitudenentscheider ausgelegt, welche die analogen Eingangssignale mit einem festen Schwellwert des Komparators vergleichen und bei Überschreiten dieses Schwellwertes die Zuordnung "EIN" bzw. bei Unterschreiten dieses Schwellwertes die Zuordnung "AUS" als jeweils entsprechendes digitales Ausgangssignal weitergeben.

In der Praxis ergeben sich bei der serienmäßigen Herstellung derartiger Betätigungsvorrichtungen, insbesondere in der Bedienung einer elektronischen Kochstellensteuerung mit mehreren optoelektronischen, jeweils mit einem Sender und einem Empfänger ausgestatteten Tastenelementen, dadurch Probleme, daß einerseits abhängig von der Strahlstärke des Senders und der Empfindlichkeit des Empfängers der Schwellwert des Komparators für jedes Tastenelement mit zugehörigem Sender-Empfänger-Pärchen individuell angepaßt und andererseits ein Sender-Empfänger-Pärchen in der Regel hinter einer Schutzfläche, insbesondere einer Ceran-Glas-Platte angeordnet ist, wodurch ungewollte innere Reflexionen an der Innenseite der Schutzfläche entstehen; weiterhin besteht die Gefahr, daß durch Temperatur- bzw. Alterungseinflüsse die vom Empfänger aufgenommenen reflektierten Signale in ihrer Intensität mit zunehmender Betriebszeit nachlassen können.

Gemäß Aufgabe vorliegender Erfindung soll daher trotz der bei der Herstellung eines Serienproduktes hinzunehmenden Streuung der eingangsseitigen Signalwerte, insbesondere aufgrund von Bauteil- und Einbautoleranzen, und trotz über einen längeren Betriebseinsatz hinzunehmender Änderungen der eingangsseitigen Signalwerte, insbesondere aufgrund von Temperatur- und Alterungseinflüssen, und unter Berücksichtigung von unerwünschten Streulicht- bzw. Fremdlichteinflüssen auf einfache Weise und ohne Notwendigkeit einer servicebedingten Justierung die sichere Erkennung eines korrespondierenden ausgangsseitigen, insbesondere digitalen, EIN-Signals bzw. AUS-Signals gewährleistet werden können. Die Lösung dieser Aufgabe gelingt durch die Lehre des Patentanspruchs 1; vorteilhafte Ausgestaltungen der Erfindung sind jeweils Gegenstand der Unteransprüche.

Durch das bei der erfindungsgemäßen Betätigungvorrichtung gezielt zusätzlich zum pulsförmigen Betätigungssignal ausgesendete und empfangene Gleich-Prüflichtsignal können aus dem Reflexionsgrad des ständig gesendeten und vom Empfänger empfangenen Gleich-Prüflichtsignals auf die Güte der Übertragungsstrecke bzw. das Maß der Reflexion geschlossen werden und entsprechend der erkennende Schwellwert im Komparator angepaßt bzw. nachgeführt werden. Ein hohes reflektiertes Gleich-Prüflichtsignal bedeutet eine gute Ankopplung zwischen Sender und Empfänger, läßt auf eine hohe Sendestrahlstärke und eine hohe Empfängerempfindlichkeit sowie eine gute Reflexion am Reflexkörper bei Betätigung, z.B. durch Auflegen eines Betätigungsfingers, schließen. Zweckmäßigerweise wird der im Empfänger detektierte Gleichlichtanteil unmittelbar zur Einstellung des Komparator-Schwellwertes für jedes einzelne Tastenelement herangezogen. Abhängig von der Amplitude des jeweiligen Gleich-Prüflichtsignals eines Tastenelementes stellt sich somit die Schaltschwelle des Komparators bei Änderung der vorgenannten beeinflussenden Größen selbsttätig ein.

Zur weiteren Bauteileminderung ist in vorteilhafter Weise vorgesehen, mehrere Tastenelemente einer Betätigungsvorrichtung nur einem einzigen Komparator zuzuordnen, wobei dann die Tastenelemente sukzessiv, insbesondere zyklisch, in Wirkverbindung mit dem Komparator stellbar sind. Die Amplitude des auf den Reflexkörper gesendeten Gleich-Prüflichtsignals ist zweckmäßigerweise derart festgelegt, daß unter Berücksichtigung der geringsten Sende- bzw. Empfangsleistung der verschiedenen optoelektronischen Tastenelemente sowie des geringsten Reflexionsgrades des Reflexkörpers eine Tastenbetätigung sämtlicher Tastenelemente eindeutig durch den Komparator detektierbar und eine unerwünschte innere Reflexion bzw. ein Fremdlicht ohne Einfluß auf die Signalauswertung bleibt.

Die Erfindung sowie weitere vorteilhafte Ausgestaltungen der Erfindung werden im folgenden anhand schematisch dargestellter Ausführungsbeispiele, insbesondere in Anwendung auf mehrere Tastenelemente in Form von elektronischen Berührungssensoren mit Infrarot-Reflexlichtschranken für eine elektronische Kochstellensteuerung, in der Zeichnung näher erläutert; darin zeigen:
- FIG 1: den grundsätzlichen Aufbau einer elektronischen Kochstellensteuerung;
- FIG 2: den zeitlichen Verlauf des Senderstromes;
- FIG 3: den zeitlichen Verlauf des jeweiligen Gesamtspannungssginals am Ausgang des Empfängers des Wechsel-Schaltsignals und des Gleich-Prüflichtsignals;
- FIG 4: den zeitlichen Verlauf der Spannung am Ausgang des Komparators;
- FIG 5: eine einfache Senderbeschaltung einer Infrarot-Reflexlichtschranke;
- FIG 6: eine einfache Empfängerbeschaltung einer elektronischen Reflexlichtschranke;
- FIG 7: ein Beispiel der Streuungsbreite der empfangenen Signale von sechs Tasten einer Kochstellensteuerung.

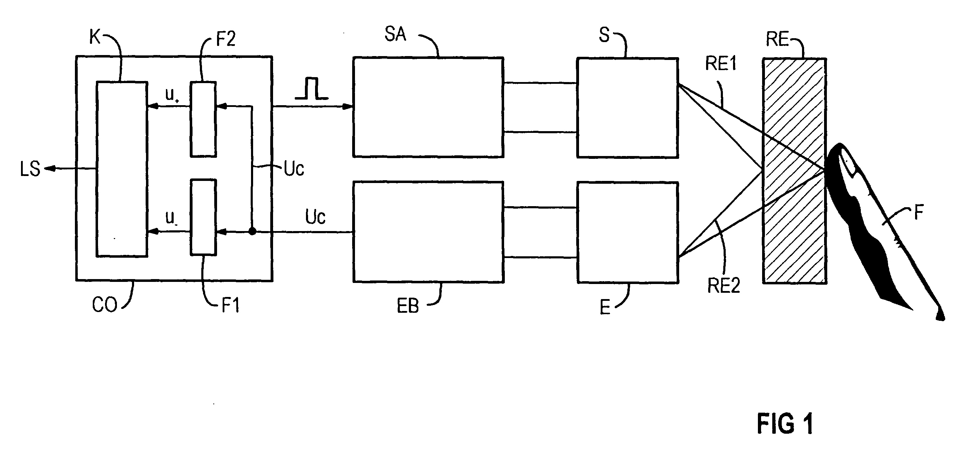

FIG 1 zeigt den Prinzipaufbau einer optoelektronischen Kochstellensteuerung mit einer berührungsempfindlichen Infrarot-Reflexlichtschranke; dazu wird von einem, z.B. in der Betätigungsvorrichtung CO integrierten, elektronischen Controller über eine Sender-Ansteuerung SA ein Sender S in Form einer im Pulsbetrieb arbeitenden Infrarot-Lichtdiode (IR-LED) pulsweise angesteuert; diesem pulsweisen Wechsellicht ist erfindungsgemäß ein Gleichlicht überlagert. Die Lichtimpulse des Senders S treffen auf eine Glasfläche RE, insbesondere die Ceranfläche einer Touchmulde einer Kochstellensteuerung, und werden von dieser bei nichtbetätigtem Berührungssensor im wesentlichen nur als Streulichtsignal RE2 aufgrund einer inneren Reflexion und bei betätigtem Tastenelement mit zusätzlichem Nutzlichtsignal RE1 aufgrund einer äußeren Reflexion zu einem Empfänger E, insbesondere einem Infrarot-Empfänger, mit einer nachfolgenden Empfänger-Beschaltung EB reflektiert; erst wenn die äußere Berührungsfläche gezielt, z.B. durch Auflegen eines Betätigungsfingers F, bedeckt und damit das Tastenelement betätigt wird, kommt es somit zu dem reflektierten Spannungs-Schaltsignal u₊, welches das Streulichtsignal derart übersteigt, daß in einem Komparator K, der zweckmäßigerweise in der elektronischen Baueinheit der Betätigungsvorrichtung CO integriert ist, aus einem Vergleich mit einem im Komparator K niedergelegten und jeweils angepaßten Schwellwert eine, insbesondere digitale, Signalerkennung zur weiteren Ansteuerung der zugehörigen Kochstelle über eine Leistungsstufe FS identifizierbar ist.

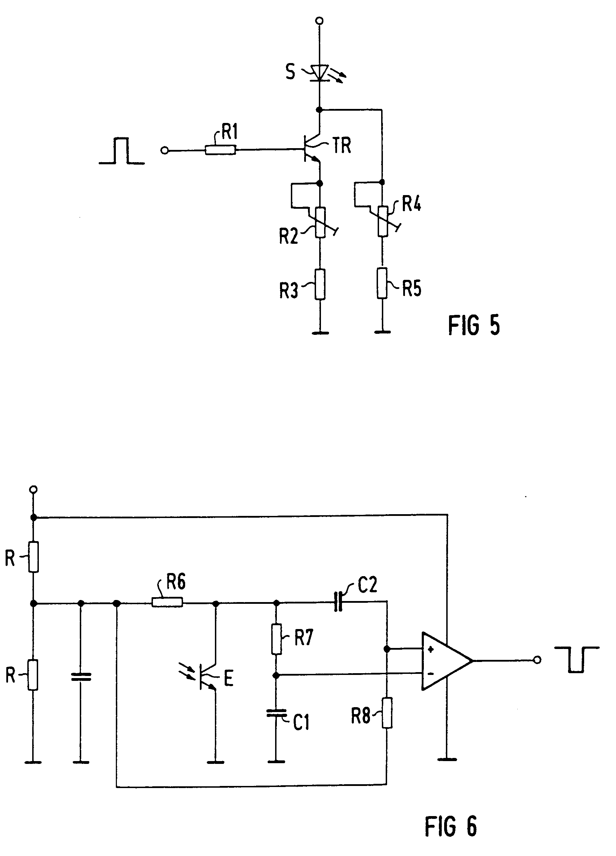

FIG 5 zeigt eine einfache Senderbeschaltung mit einem über einen Vorwiderstand R1 pulsweise angesteuerten, im Schaltbetrieb arbeitenden Kleinsignal-Transistor TR, der in Reihe mit einem oder mehreren Sendern S in Form von Infrarot-Leuchtdioden (IR-LED) liegt. Mit einem veränderlichen Widerstand R2 mit Vorwiderstand R3 kann die Amplitude des gepulsten Wechsel-Betätigungssignals eingestellt werden. Mit einem weiteren veränderlichen Widerstand R4 mit Vorwiderstand R5 zwischen dem Kollektor des Transistors TR und Masse kann die Amplitude des ständig durch den Sender S fließenden Gleichstroms und damit das Gleich-Prüflichtsignal eingestellt werden.

FIG 6 zeigt eine einfache Empfängerbeschaltung. Mittels eines Spannungsteilers R/R mit zugehörigem Kondensator C3 wird eine niederohmige Hilfsspannung als Bezugspotential festgelegt, deren Spannungsniveau der Hälfte der Versorgungsspannung entspricht. Als Empfänger E dient ein Fototransistor, dem ein Lastwiderstand R6 vorgeschaltet ist und an dessen Kollektor das jeweils empfangene reflektierte Signal abgreifbar ist. Durch einen Tiefpaßfilter R7/C1 wird der DC-Anteil ausgekoppelt und liegt am invertierenden Eingang des Komparators K als reflektiertes Gleich-Prüflichtsignal u₋ und gleichzeitiges Spannungs-Referenzsignal an. Da der Filter R7/C1 als Tiefpaß ausgebildet ist, wird die Spannung am Kondensator C1 durch die Wechselanteile des Signals nicht beeinflußt.

Der AC-Anteil des jeweils empfangenen reflektierten Signals wird über einen Hochpaß C2/R8 ausgekoppelt und liegt an einem nichtinvertierenden Eingang des Komparators K als jeweiliger Spannungswert eines Wechsel-Schaltsignals u₊ an. Erst wenn die Amplitude dieses am nichtinvertierenden Eingang des Komparators K anliegende Wechsel-Schaltsignal u₊ groß genug ist, den DC-Pegel des aus dem reflektierten Gleich-Prüflichtsignals u₋ abgeleiteten Spannungs-Referenzsignals am invertierenden Eingang des Komparators K zu unterschreiten, schaltet der Komparator K um und gibt ein eine Betätigung des Tastenelementes kennzeichnendes Pulssignal zur Weiterverarbeitung, z.B. an eine Leistungstufe LS ab. Zweckmäßigerweise wird ein Komparator K vorgesehen, der einen hohen Eingangswiderstand gegenüber dem Widerstand R6 besitzt und den Kondensator C1 nicht belastet. Außerdem ist zur Verhinderung eines instabilen Verhaltens des Komparators K die sich am Widerstand R8 einstellende Spannung bei statischer Belastung immer etwas größer als die Spannung am Kondensator C1.

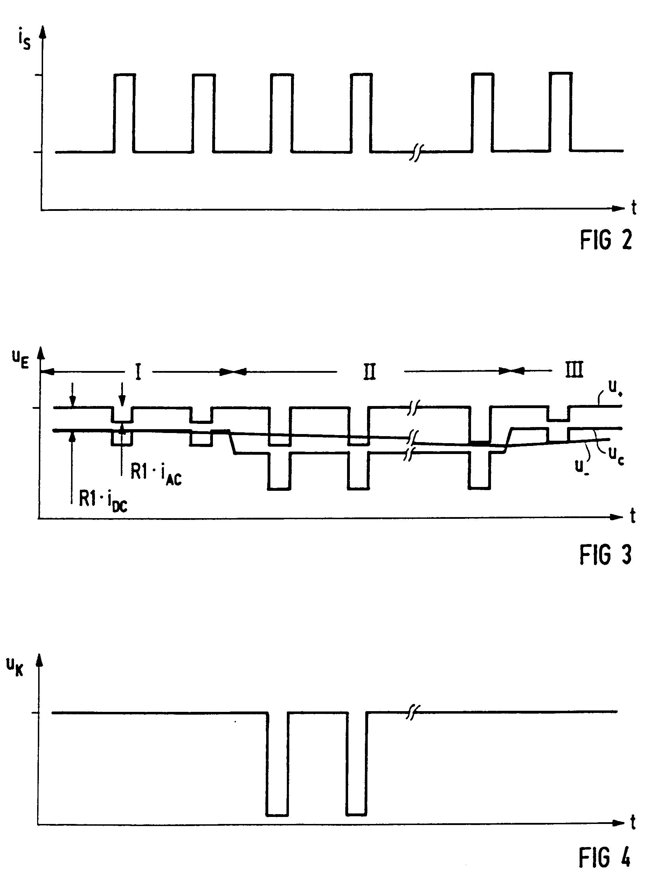

FIG 2 zeigt den Stromverlauf an der Infrarot-Leuchtdiode des Senders S; dieser Strom setzt sich zusammen aus einem Gleichanteil I_{DC} für das Gleich-Prüflichtsignal sowie einem Wechselstromanteil I_{AC} für das Wechsel-Schaltsignal.

FIG 3 zeigt die Spannungsverläufe der Gesamtspannung u_{c} am Kollektor des als Empfänger E vorgesehenen Fototransistors sowie das reflektierte ausgefilterte Gleich-Prüflichtsignal bzw. Spannungs-Referenzsignal u₋ am invertierenden Eingang des Komparators K und das Spannungs-Schaltsignal u₊ am nichtinvertierenden Eingang des Komparators K jeweils während einer Nichtbetätigung des Tastenelementes im Bereich I, einer kurzzeitigen Betätigung des Tastenelementes im Bereich II und einer unbeabsichtigten zu langen Betätigung des Tastenelementes im Bereich III. Wahrend des Bereichs I ergibt sich, ausgehend von dem durch die Spannungsteilerschaltung R/R gemäß FIG 6 bestimmten Mittenspannungsniveau, eine überlagerte Gesamtspannung u_{C} aus dem Wechsel-Schaltsignal u₊ bzw. dem Gleich-Prüflichtsignal u₋. Bei Betätigung des Tastenelementes vergrößert sich aufgrund der Reflexion die Amplitude des empfangenen Wechsel-Schaltsignals u₊ sowie das Gleich-Prüflichtsignal u₋; wenn nunmehr die Amplitude des reflektierten Wechsel-Schaltsignals u₊ die als Schwellwert dem Komparator K vorgegebene Amplitude des Gleich-Prüflichtsignals u₋ übersteigt, schaltet der Komparator K - wie aus dem Spannungsverlauf u_{K} am Ausgang des Komparators gemäß FIG 6 ersichtlich - um.
Die AC-Amplitude des Senderstromes wird zweckmäßigerweise so eingestellt, daß unter Berücksichtigung des Senders S mit der geringsten Strahlstärke und des Empfängers E mit der geringsten Empfindlichkeit bei Tastenbetätigung eindeutig ein Signal erkannt wird; dann ist die DC-Amplitude des Gleich-Prüflichtsignals u₋ soweit zu erhöhen, daß eine innere Reflexion (Streulicht) unterdrückt wird und der Komparator K ohne Betätigung, d.h. Berührung des Tastenelementes T1-T6, nicht umschaltet. Wenn die Amplitude des DC-Signals noch weiter erhöht wird, kann erreicht werden, daß der Wert des Spannungs-Referenzsignals u₋ am invertierenden Eingang des Komparators K gemäß der durch den Tiefpaß R7;C1 vorgebbaren Zeitkonstante unterhalb des Niveaus des Wechsel-Schaltsignals u₊ verläuft und somit der Komparator K wieder zurückschaltet und ein Wechsel-Schaltsignal u₊ unterdrückt; dadurch kann in vorteilhafter Weise erreicht werden, daß eine zulange bzw. fehlerhaft durch Auflegen eines reflektierenden Gegenstandes betätigtes Tastenelement als Fehlfunktion erkannt und entsprechend ignoriert wird. Diese Verhältnisse sind in FIG 3 und FIG 4 im Bereich III dargestellt.

FIG 7 zeigt als Beispiel verschiedene Streubereiche von sechs Tastenelementen jeweils für die EIN-Signalpegel bzw. die dazu im Abstand a1-a6 sich ergebenden AUS-Signalpegel in Form von analogen Spannungsamplituden der pulsweisen Signale bei Betätigung bzw. Nichtbetätigung der sechs Tastenelemente T1-T6 einer Kochstellensteuerung.

Es dürfte ersichtlich sein, daß bei der erfindungsgemäßen Betätigungsvorrichtung eine eindeutige Tastenerkennung unter Berücksichtigung von Bauteiltoleranzen, Einbautoleranzen sowie Alterungs- und Temperatureinflüssen ohne Notwendigkeit einer in gesonderten Justierarbeiten jeweils abzugleichende Schaltschwelle aufgrund deren Selbstnachführung durch Erkennen des Reflexionsgrades eines dem Wechsel-Nutzlichtsignals überlagerten Gleich-Prüflichtsignals gewährleistet werden kann.

## Patentansprüche

1. Betätigungsvorrichtung mit zumindest einem optoelektronischen Tastenelement (T1-T6), insbesondere einer berührungsempfindlichen Reflexlichtschranke, und mit einem Komparator (K) zur Erkennung einer Tastenbetätigung durch Vergleich eines dabei von einem Reflexkörper (RE) reflektierten, insbesondere pulsförmigen, Wechsel-Schaltsignals (u₊) mit einem Schwellwert (u_{c}), der in Einstell- bzw. Nachführabhängigkeit vom Reflexionsgrad eines auf den Reflexkörper (RE) gesendeten und von diesem reflektierten Gleich-Prüflichtsignals (u₋) steht.

2. Betätigungsvorrichtung nach dem vorhergehenden Anspruch mit mehreren Tastenelementen (T1-T6) mit jedem Tastenelement (T1-T6) zugeordnetem Sender (S) bzw. Empfänger (E),

3. Betätigungsvorrichtung nach zumindest einem der vorhergehenden Ansprüche mit mehreren Tastenelementen (T1-T6) mit je einer berührungsempfindlichen Infrarot-Reflexlichtschranke für eine Kochstellensteuerung.

4. Betätigungsvorrichtung nach zumindest einem der vorhergehenden Ansprüche mit einem einzigen Komparator (K) zugeordneten mehreren Tastenelementen (T1-T6), wobei die Tastenelemente (T1-T6) sukzessiv, insbesondere zyklisch, in Wirkverbindung mit dem Komparator (K) stellbar sind.

5. Betätigungsvorrichtung nach zumindest einem der vorhergehenden Ansprüche mit einer derartigen Amplitude des auf den Reflexkörper (RE) gesendeten Gleich-Prüflichtsignals, daß unter Berücksichtigung der geringsten Sende- bzw. Empfangsleistung der optoelektronischen Tastenelemente (T1-T6) sowie des geringsten Reflexionsgrades des Reflexkörpers eine Tastenbetätigung der Tastenelemente (T1-T6) eindeutig durch den Komparator (K) detektierbar ist.

6. Betätigungsvorrichtung nach Anspruch 4 mit einer derartigen Amplitude des auf den Reflexkörper (RE) gesendeten Gleich-Prüflichtsignals, daß unter Berücksichtigung eines aufgrund lediglich einer inneren Reflexion reflektierten maximalen Streulichts eine Nicht-Tastenbetätigung eindeutig detektierbar ist.

7. Betätigungsvorrichtung nach zumindest einem der vorhergehenden Ansprüche mit jeweils zwischen einem Empfänger (E) für die reflektierten Lichtsignale und dem Komparator (K) ersten Verbindungsweg mit einem Hochpaßfilter (F1) für ein reflektiertes Wechsel-Schaltsignal (u₊) und einem zweiten Verbindungsweg mit einem Tiefpaßfilter (F2) für ein reflektiertes Gleich-Prüflichtsignal (u₋).

8. Betätigungsvorrichtung nach zumindest einem der vorhergehenden Ansprüche mit einer zeitkonstantenabhängig einstellbaren Amplitude des Spannungs-Referenzsignals u₋ an dem einen Eingang des Komparators (K) im Sinne einer Unterdrückung des reflektierten Wechsel-Schaltsignals u₊ an dem anderen Eingang des Komparators (K) bei übermäßig zeitlängerer Betätigung des Tastenelementes (T1-T6).
